# EUROPEAN PATENT SPECIFICATION

(11) **EP 1 544 901 B1**
(45) Date of publication and mention of the grant of the patent: **16.12.2009**
(21) Application number: 03798500.9
(22) Date of filing: 25.09.2003
(51) Int. Cl.: H01L 21/321, C09K 3/14, C09G 1/02

(54) **Polishing compound composition and polishing method**
Poliermittelzusammensetzung und Polierverfahren
Composition de composé de polissage et procédé de polissage

(30) Priority: 25.09.2002 JP 2002279193
(43) Date of publication of application: 22.06.2005
(73) Proprietor: SEIMI CHEMICAL CO., LTD., Chigasaki-city, Kanagawa, 253-8585 (JP); ASAHI GLASS COMPANY LTD., Tokyo 100-8405 (JP)
(72) Inventor: KAMIYA, Hiroyuki Asahi Glass Company, Limited, Yokohama-shi Kanagawa 221-8755 (JP); TSUGITA, Katsuyuki Seimi Chemical Co., Ltd., Chigasaki-shi Kanagawa 253-8585 (JP)
(74) Representative: Müller-Boré & Partner Patentanwälte
(86) International application number: PCT/JP2003/012258
(87) International publication number: WO 2004/030062

(56) References cited:
- JP-A- 2001 023 940
- JP-A- 2001 031 950
- JP-A- 2001 127 020
- JP-A- 2002 170 790
- JP-A- 2002 201 462
- JP-A- 2002 270 546
- US-A- 6 063 306
- US-A1- 2002 098 697

## Description

### TECHNICAL FIELD

The present invention relates to a polishing compound. Particularly, it relates to a polishing compound to be used in a process for producing a semiconductor integrated circuit board. More particularly, it relates to a polishing compound which is suitable for forming an embedded copper wiring in which tantalum or a tantalum compound is used as the material for a barrier film, and a process for producing a semiconductor integrated circuit board using the polishing compound.

### BACKGROUND ART

Recently, as the integration and functionality of semiconductor integrated circuits have been increasing, there has been a demand for development of microfabrication techniques for miniaturization and densification. Planarization techniques for interlayer insulating films and embedded wirings are important in semiconductor integrated circuit production processes, in particular, in the process of forming multilayered wirings. That is, as the multilayered wirings are increasingly formed due to the miniaturization and densification in the semiconductor production processes, the degree of irregularity tends to increase in the surfaces of the individual layers, resulting in a situation where the difference in level exceeds the depth of focus in lithography. In order to avoid such a problem, high planarization techniques are important in the process of forming multilayered wirings.

As the material for such wirings, copper has been receiving attention because of its lower resistivity compared with conventionally used Al alloys and also because of its excellence in electromigration resistance. Since the vapor pressure of copper chloride gas is low, it is difficult to form copper into the shape of wirings by Reactive Ion Etching (RIE) which has been conventionally used. Therefore, in order to form the wirings, a Damascene method is used. In this process, gap fillings such as trench patterns and via holes, are formed in an insulating film. A barrier film is then formed thereon, and then copper is deposited so as to be embedded in the trench portions to form a film by sputtering, plating, or the like. Subsequently, the excess copper and the barrier film are removed by Chemical Mechanical Polishing (hereinafter referred to as "CMP") until the surface of the insulating film is exposed, other than the portions corresponding to the recesses, whereby the surface is planarized. Recently, a Dual Damascene method has been predominantly used, in which copper wirings embedded with copper and via holes are simultaneously formed.

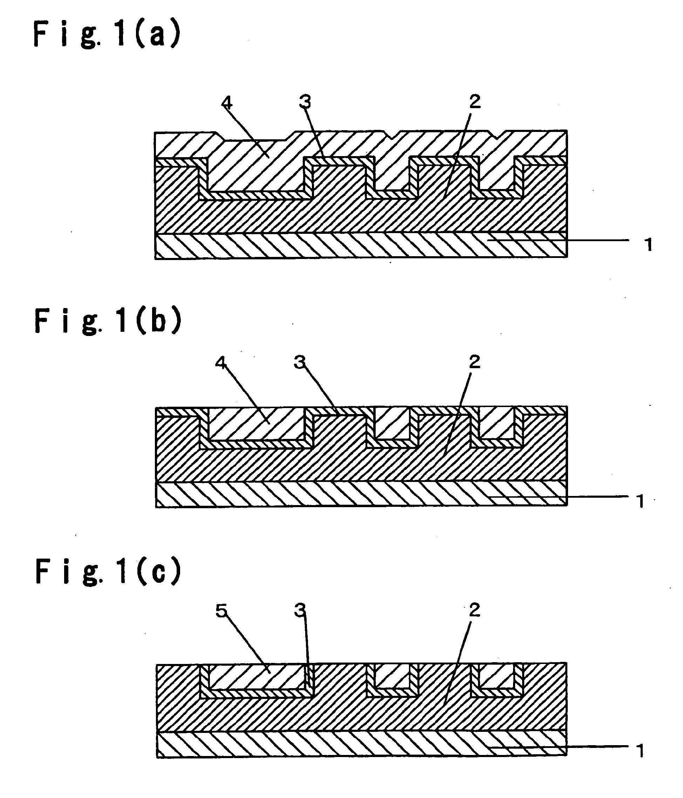

In the formation of copper embedded wirings, in order to prevent copper from diffusing into the insulating film, a barrier film composed of tantalum, a tantalum alloy, or a tantalum compound such as tantalum nitride, is formed. Therefore, in the portions other than those corresponding to copper-embedded wirings, the exposed barrier film must be removed by CMP. However, since the barrier film is significantly harder than copper, it is often not possible to achieve a sufficient removal rate. Accordingly, a two-stage polishing method has been proposed, which includes a first polishing step of removing the wiring metal film and a second polishing step of removing the barrier film, as shown in Fig. 1.

Fig. 1 includes cross-sectional views which show a method for forming embedded wirings by CMP. Fig. 1(a) shows the state before polishing; Fig. 1(b) shows the state after the first polishing step in which a wiring metal film 4 is removed; and Fig. 1(c) shows the state after the second polishing step in which a barrier film 3 is removed. As shown in Fig. 1(a), an insulating film 2 provided with trenches for forming embedded wirings 5 is formed on a Si board 1. The barrier film 3 is formed on the insulating film 2, and the wiring metal film (Cu film) 4 is formed further thereon. The wiring metal film 4 is removed in the first polishing step, and the barrier film 3 is removed in the second polishing step.

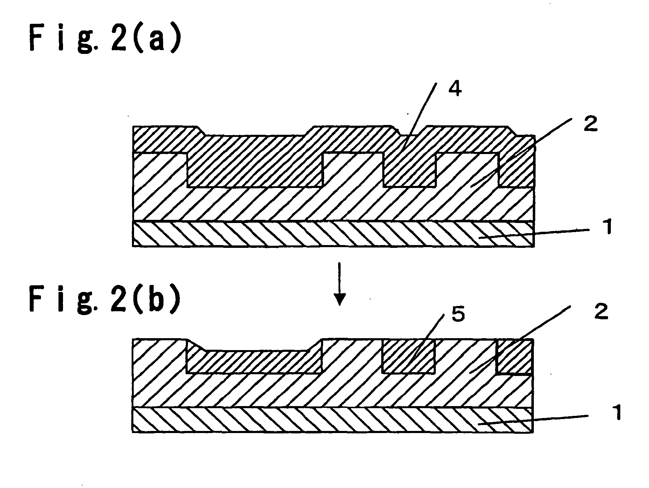

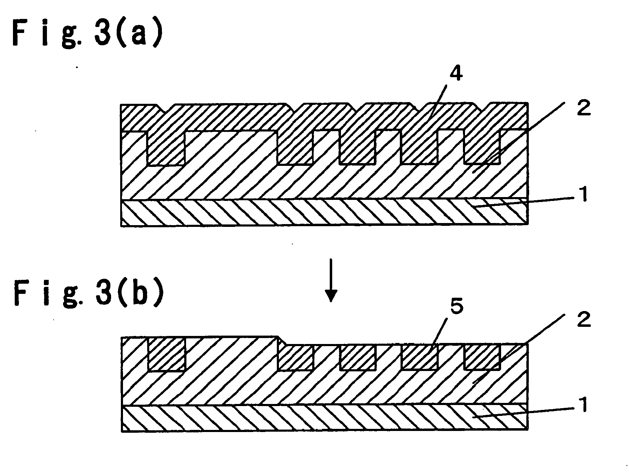

However, in CMP using the conventional polishing compound, an increase in dishing and erosion in the copper-embedded wirings 5 will give rise to problems. Here, dishing is likely to occur in a wide wiring portion, and signifies a state in which the wiring metal film 4 in the wiring portion is over-polished so that the central part thereof is concaved as shown in Fig. 2. Erosion is likely to occur in a dense wiring portion, and signifies such a phenomenon that the insulating film 2 in the dense wiring portion is over-polished and the insulating film 2 becomes thin as shown in Fig. 3. In Figs. 2 and 3, the barrier film 3 is not shown.

The above first polishing step may be carried out in two stages in some cases. The first stage step is to remove copper up to a portion in the vicinity of the barrier film material at a high removal rate, and the second stage step is to polish the surface of the barrier film material at a different removal rate so that no dishing nor erosion will take place.

In the second polishing step, the copper wirings, the barrier film and the insulating film are polished usually substantially at the same rate. Accordingly, in a case where no flat plane is obtained in the first polishing step of removing copper on portions other than the wiring portion, dishing or erosion will be induced at the wiring portion even in the second polishing step, and no wiring structure with flat surface will be finally formed. Accordingly, it is required for a polishing compound for the first polishing step that it has such a selectivity that the removal rate of copper is high and the removal rate of the barrier film is very low, and that dishing or erosion hardly occurs, and various polishing compounds have been proposed (e.g. JP-A-2002-170790 ; US-A1-0 098 697 ; US-A1-6 063 306 ; JPA-2001-023940).

On the other hand, for the insulating film on a semiconductor board, mainly an inorganic material such as SiO₂ has conventionally been used. However, along with an increase in density of wirings for high integration of a semiconductor integrated circuit in recent years, a new material having a low dielectric constant, called a low-k material, has been receiving attention. However, many of low-k materials are made of an organic material or a mixed material of organic and inorganic materials. Accordingly, polishing by conventional CMP process may bring about a problem of peeling of the insulating film itself, in addition to a problem of irregularities and scars on the surface of the semiconductor integrated circuit board. In order to prevent the peeling, a CMP process capable of providing a removal rate as high as conventional one even under a low polishing pressure, and a polishing compound therefor have been required.

### DISCLOSURE OF THE INVENTION

Under these circumstances, it is an object of the present invention to provide a polishing compound particularly suitable for polishing a semiconductor integrated circuit board, which has such polishing selectivity that it can polish copper at a high removal rate even under a low polishing pressure and it provides a low removal rate of tantalum or a tantalum compound to be a barrier film, which thereby suppresses wiring defects such as dishing, erosion or peeling of the insulating film, in CMP process particularly in a process for producing a semiconductor integrated circuit board in which copper embedded wiring are formed; and a process for producing a semiconductor integrated circuit board using the polishing compound.

The present invention provides a polishing compound for chemical mechanical polishing of a substrate, comprising the following components (A), (B), (C), (D) and (E):
(A) abrasive grains
(B) aqueous medium
(C) tartaric acid
(D) trishydroxymethylaminomethane
(E) at least one member selected from the group consisting of malonic acid and maleic acid.

The polishing compound of the present invention (hereinafter referred to as the present polishing compound) provides a high removal rate of copper even when polishing is carried out under a low pressure, and is therefore suitable for polishing copper. Further, in this case, erosion or dishing is less likely to occur. Further, it provides a low removal rate of tantalum or a tantalum compound such as tantalum nitride, and accordingly when the present polishing compound is used for the first polishing step in production of a semiconductor integrated circuit board in which copper embedded wirings are formed, employing tantalum or a tantalum compound as a barrier film, excellent selectivity will be obtained such that the removal rate of copper is high and the removal rate of the barrier film is low.

The present invention further provides a process for producing a semiconductor integrated circuit board, which comprises forming an insulating film on a wafer, and forming copper embedded wirings in the insulating film by means of a barrier film made of tantalum or a tantalum compound, characterized by having steps of bringing the surface of the wafer into contact with a polishing pad, supplying the above polishing compound to a space between the board and the polishing pad, and polishing copper formed on the surface of the wafer.

### BRIEF EXPLANATION OF THE DRAWINGS

Fig. 1: cross-sectional views illustrating a process of forming embedded wirings by CMP.
   (a) before polishing, (b) after completion of the first polishing step of removing a wiring metal film, (c) after completion of the second polishing step of removing a barrier film
Fig. 2: cross-sectional views illustrating the process of the generation of dishing.
   (a) before polishing, (b) after polishing
Fig. 3: cross-sectional views illustrating the process of the generation of erosion
   (a) before polishing, (b) after polishing

### BEST MODE FOR CARRYING OUT THE INVENTION

The present polishing compound contains the following components (A) to (E). (A) abrasive grains, (B) an aqueous medium, (C) tartaric acid, (D)trishydroxymethylaminomethane (hereinafter referred to as THMAM) and (E) at least one member selected from the group consisting of malonic acid and maleic acid.

The abrasive grains as the component (A) contained in the present polishing compound may, for example, be composed of an aluminum oxide such as α-alumina, β-alumina, δ-alumina, γ-alumina or θ-alumina, or ceria or silica. These abrasive grains may be used alone or in combination, and abrasive grains composed of another inorganic material or organic material may also be contained within a range not to have a bad influence over the semiconductor integrated circuit.

In a case where the abrasive grains are composed of alumina, the average particle size is preferably from 0.001 to 0.5 µm, more preferably from 0.01 to 0.3 µm. Among aluminas, δ-alumina is particularly preferred. Further, the alumina contained in the present polishing compound is preferably from 0.05 to 5 mass%, more preferably from 0.09 to 3 mass%.

In a case where the abrasive grains are composed of ceria, the average particle size is preferably from 0.001 to 0.5 µm, more preferably from 0.01 to 0.3 µm. Further, the ceria contained in the present polishing compound is preferably from 0.1 to 10 mass%, more preferably from 1 to 5 mass%.

In a case where the abrasive grains are composed of silica, the average particle size is preferably from 0.001 to 0.5 µm, more preferably from 0.01 to 0.3 µm. Further, the silica contained in the present polishing compound is preferably from 0.5 to 15 mass%, more preferably from 1 to 10 mass%.

If the particle size of the abrasive grains is too small, no adequate removal rate will be obtained, and if the particle size is too large, the polished surface will be scared. When alumina, silica and ceria have average particle sizes within the above ranges, a high removal rate can be maintained and at the same time the polished surface is less likely to be scared. Here, the average particle size of the abrasive grains is a value obtained by dispersing in water the abrasive grains in a state before they are mixed with another component, and measured by means of laser scattering, and it may be measured, for example, by Microtrac HRA model 9320-X100 manufactured by NIKKISO Co., Ltd.

Further, if the content of the abrasive grains in the polishing compound is too low, the removal rate tends to be low, and if the content of the abrasive grains is too high, the viscosity of the polishing compound tends to be high, and the handling will be difficult. Further, the polished surface is more likely to be scared. When the contents of alumina, silica and ceria are within the above ranges, a high removal rate can be maintained and at the same time, the viscosity of the polishing compound will not be too high.

Further, when a semiconductor integrated circuit board is produced, it is necessary to avoid inclusion of impurities which have a bad influence over the circuit. Accordingly, particularly when used for polishing a semiconductor integrated circuit board, the abrasive grains in the present polishing compound are preferably composed of a high purity oxide having a purity of at least 99%, more preferably at least 99.5%. In a case where the abrasive grains are composed of plural types of abrasive grains, it is preferred that a plurality of abrasive grains each having a purity of at least 99% are mixed. In view of purity, it is preferred that sodium ions, etc., which particularly have a bad influence over a semiconductor integrated circuit, are not mixed in the abrasive grains.

As the component (B), it is preferred to use high purity water such as ion-exchanged water by itself. However, it may be a mixed dispersion medium comprising water as the main component and containing an organic solvent soluble in water, such as an alcohol. The alcohol is not particularly limited, and it may, for example, be an aliphatic alcohol having a C₁₋₅ alkyl group such as ethanol, propanol or butanol. The component (B) preferably comprises water alone considering easiness of washing of an object to be polished after polishing, influence of volatile components over working environment, etc.

Three components i.e. tartaric acid as the component (C), THMAM as the component (D) and at least one member selected from the group consisting of malonic acid and maleic acid as the component (E), increase the polishing characteristics by combination of these three components. When only one or two components of the above three components are contained in the polishing compound, such characteristics can not be obtained that the removal rate of copper is high, the removal rate of tantalum or a tantalum compound is low, and a problem of e.g. dishing is less likely to occur. The above characteristics can be obtained only when the three components are contained.

When THMAM is contained in the polishing compound, the removal rate of tantalum or a tantalum compound tends to be low. In order that the removal rate of copper is increased and the problem of e.g. dishing or erosion is less likely to occur, while maintaining these characteristics, it is necessary to add the above components (C) and (E). No adequate removal rate will be obtained, although the problem of dishing is less likely to occur, when only tartaric acid as the component (C) is added to the polishing compound containing THMAM. A high removal rate of copper will be obtained even under a low polishing pressure, a low removal rate of tantalum or the like will be obtained, and the problem of e.g. dishing is less likely to occur, only when the polishing compound contains three components (C), (D) and (E).

Here, the content of tartaric acid in the present polishing compound is preferably from 0.01 to 10 mass%, more preferably from 0.1 to 2 mass%, to the total mass of the present polishing compound. Further, the content of THMAM is preferably from 0.1 to 10 mass%, more preferably from 1 to 8 mass%. Further, the content of malonic acid and/or maleic acid is preferably from 0.01 to 10 mass%, more preferably from 0.1 to 2 mass% in total. If the contents of these components are too low, the above effects will not sufficiently be obtained, and no sufficient removal rate may be obtained. On the other hand, if the contents are higher than the above ranges, no further increase in the effect by addition will be obtained.

The present polishing compound preferably contains, in addition to the components (A) to (E), a compound having a function to form a protective film on the wiring metal surface so as to prevent dishing at the wiring metal portion. Specifically, a compound represented by the formula 1 is preferably contained. The compound represented by the formula 1, in a case where the wiring metal is copper, is physically or chemically adsorbed on the copper surface to form a film and thereby suppresses elution of copper. In the formula 1, R is a hydrogen atom, a C₁₋₄ alkyl group, a C₁₋₄ alkoxy group or a carboxylic acid group:

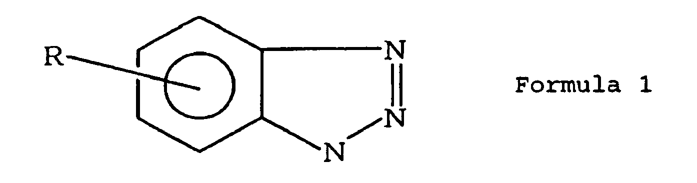

Specifically, benzotriazole (hereinafter referred to as BTA), tolyltriazole (TTA) having one hydrogen atom at the 4- or 5-position of the benzene ring of BTA substituted by a methyl group, benzotriazole-4-carboxylic acid having a hydrogen atom substituted by a carboxylic acid group may, for example, be mentioned. They may be used alone or as a mixture of at least two. The above compound having a function to form a protective film is contained in an amount of preferably from 0.001 to 5 mass%, more preferably from 0.005 to 0.5 mass%, furthermore preferably from 0.005 to 0.1 mass%, to the total mass of the present polishing compound, in view of polishing characteristics.

Further, the present polishing compound preferably contains an oxidizing agent. The effect of the oxidizing agent is not necessarily clear, but is considered to accelerate polishing in such a manner that it forms an oxidized film on the surface of copper as an object to be polished, and the oxidized film is removed from the surface of the board by a mechanical force. However, if the content of the oxidizing agent is too high, the corrosion rate of copper may be high. Thus, it is contained in an amount of preferably from 0.1 to 10%, more preferably from 0.5 to 5%, to the total mass of the present polishing compound. As the oxidizing agent, hydrogen peroxide, urea peroxide, acetic peracid, ferric nitrate or iodate may, for example, be used, and hydrogen peroxide is particularly preferred in view of less stains of the semiconductor board.

The present polishing compound may further optionally contain a pH adjusting agent, a surfactant, a chelating agent, a reducing agent, etc. as the case requires.

The pH of the present polishing compound is preferably from 5 to 8. Within this range, the copper surface is less likely to be corroded and a high removal rate of copper can be maintained. Usually, the pH may be adjusted by the amounts of the acids and THMAM in the polishing compound, but a pH adjuster may be contained. In such a case, the pH adjuster is not particularly limited within a range not to impair the polishing performance, and a known acid or alkali may be used. Specifically, for example, the pH adjuster to the acidic side may be an inorganic acid such as nitric acid, sulfuric acid or hydrochloric acid or an organic acid such as acetic acid, propionic acid, lactic acid, citric acid, oxalic acid or succinic acid.

Further, the pH adjuster to the basic side may, for example, be an alkali metal compound such as potassium hydroxide, a primary to tertiary amine, hydroxylamine or a quaternary ammonium salt such as tetramethyl ammonium hydroxide or tetraethyl ammonium hydroxide. In the present invention, the pH may be adjusted to the basic side by adjusting the amount of THMAM. In a case where no alkali metal is preferably contained, ammonia is used in many cases. However, if ammonia is contained, the removal rate of tantalum or the like tends to increase, and the selectivity will decrease. Particularly when used for polishing a semiconductor integrated circuit board with copper wirings employing tantalum or a tantalum compound as a barrier film, the amount of ammonia is preferably small even if it is contained in the polishing compound, and substantially no ammonia is preferably contained in some cases.

On the other hand, when ammonia is contained in the present polishing compound, the removal rate of copper tends to increase. Accordingly, when the compound is used for polishing a semiconductor integrated circuit board with copper wirings employing tantalum or a tantalum compound as a barrier film, and when it is attempted to increase the removal rate of copper even if the above selectivity is somewhat decreased, it is preferred to incorporate ammonia into the present polishing compound at such a level that the removal rate of tantalum or the like will not increase. Specifically, in a case where ammonia is contained in the present polishing compound, the content of ammonia is preferably from 0.05 to 0.4%, particularly preferably from 0.1 to 0.3% to the total mass of the present polishing compound.

Further, a surfactant may be added with a purpose of improving dispersibility of the polishing compound and preventing roughening of the copper surface after polishing. As the surfactant, any of an anionic surfactant, a cationic surfactant, a nonionic surfactant and an amphoteric surfactant may be used.

The anionic surfactant may, for example, be ammonium lauryl sulfate, polyacrylic acid, an alkyl sulfate or an alkylbenzene sulfonate. The cationic surfactant may, for example, be an alkylamine salt or a quaternary ammonium salt. The nonionic surfactant may, for example, be a polyoxyethylene derivative, a polyoxyethylene sorbitan fatty acid ester or a glycerol fatty acid ester. The amphoteric surfactant may, for example, be an alkyl betaine or an amine oxide.

The chelating agent may, for example, be an amino acid such as glycine, alanine, glutamine or asparagine, a peptide such as glycylglycine or glycylalanine, a polyaminocarboxylic acid such as EDTA, an oxycarboxylic acid such as citric acid or a condensed phosphoric acid. Further, a metal chelate may be contained, and when copper is polished for example, anthranilic acid copper chelate or quinaldic acid copper chelate may, for example, be used.

Further, as the reducing agent, a hydrogen compound such as hydrogen iodide or hydrogen sulfide or a known organic compound such as an aldehyde, a sugar, formic acid or oxalic acid may be used.

The present polishing compound is useful for polishing copper, and is useful particularly for polishing for production of a semiconductor integrated circuit board having a film made of tantalum or a tantalum compound as a barrier film between an insulating film and copper. A method wherein the rear face of a semiconductor wafer board having a semiconductor integrated circuit formed on the surface of the wafer, is held by a rotatable polishing head, pressed on a polishing pad fixed on a rotatable support and rotated, or a method wherein the rear face of a semiconductor wafer board having a semiconductor integrated circuit formed on the surface of the wafer is fixed on a rotatable support, and a polishing head equipped with a polishing pad is brought into contact with the surface of the semiconductor integrated circuit and rotated, may, for example, be employed.

Preferred is a method of polishing copper formed on the surface of the board, by bringing the surface of the board into contact with the polishing pad and supplying the present polishing compound to a space between the surface of the board and the polishing pad.

Here, the semiconductor integrated circuit board may be attached to the support by means of a cushioning material so as to absorb the pressure during polishing and uniformly apply a pressure to the surface of the semiconductor integrated circuit board. Further, the polishing pad may have channels or supply ports so that the polishing compound in the slurry form can be uniformly supplied to the surface of the semiconductor integrated circuit board.

The material of the polishing pad may, for example, be a polyester or a polyurethane, and in Examples of the present invention, IC-1000 K-Grooved (made of polyurethane, manufactured by Rodel, Inc.) was employed. However, the material of the polishing pad used is not limited thereto, and may optionally be selected depending upon the polishing compound used.

The polishing pressure may be set depending upon the type of the polishing pad, presence or absence and the type of the cushioning material, the removal rate and the physical properties of the polishing compound such as the viscosity of the slurry. However, the present polishing compound can provide a high removal rate of copper even under a low polishing pressure. Accordingly, the present polishing compound is very useful for polishing of a semiconductor integrated circuit board in which copper embedded wirings are formed in an insulating film made of an organic material or an organic/inorganic composite material having a low dielectric constant (e.g. relative dielectric constant of from 1.0 to 3.5) by means of a barrier film made of tantalum or a tantalum compound. This is because an insulating film made of an organic material or an organic/inorganic composite material has low strength as compared with an insulating film made of an inorganic material such as SiO₂, and the insulating film may be peeled from the board when polished under a high polishing pressure, and accordingly it is polished preferably under a low polishing pressure.

In such a case, the polishing pressure is preferably from 0.7×10³ to 3.5×10⁴ Pa, particularly preferably from 0.35×10⁴ to 2.1×10⁴ Pa. If the polishing pressure is lower than 0.7×10³ Pa, no adequate removal rate will be obtained, and on the other hand, if it is higher than 2.1×10⁴ Pa, dishing, erosion or scars may occur during polishing, or the insulating film may be peeled off due to the insulating film made of an inorganic material or an organic/inorganic composite material, and thus the circuit formed on the semiconductor wafer or formation of multilayered structure of circuits after polishing may be impaired.

On a semiconductor integrated circuit board, after completion of the first polishing step of polishing copper by using the polishing compound of the present invention as described above, the second polishing step of polishing copper and a barrier film is carried out. Further, in a case where the first polishing step consists of a first stage step of removing copper up to a portion in the vicinity of the insulating film material at a high removal rate and a second stage step of polishing the surface of the insulating film material at a different removal rate so that dishing or erosion will not occur, a particularly high effect will be obtained when the present polishing compound is used in the first stage step.

After completion of the second polishing step by CMP, usually the semiconductor integrated circuit board is adequately washed with running water and dried. Ultrasonic cleaning is carried out in many cases.

Now, the present invention will be explained in further detail with reference to Examples of the present invention (Examples 1, 2, 4, 7 and 8 and Comparative Examples (Examples 3, 5 and 6).

### (Object to be polished)

### (Blanket wafers)

(1) Wafer for evaluating removal rate of copper (wiring metal film): 8-inch wafer board having a 1,500 nm thick Cu layer deposited thereon by plating
(2) Wafer for evaluating removal rate of tantalum (barrier film): 8-inch wafer board and a 200 nm thick Ta layer deposited thereon by sputtering

### (Patterned wafer)

An 8-inch wafer (trade name: 831CMP000, made by International SEMATECH) fabricated by forming a line pattern with a line density of 50% and a line width of 50 µm on an insulating film formed on a board, forming a 25 nm thick Ta layer by sputtering on the line-pattern-formed insulating film, and further forming thereon a 1500 nm thick Cu layer by plating.

### EXAMPLES 1 to 3

Using a polishing compound having a composition as shown in Table 1, polishing was carried out on a wafer for evaluating removal rate of copper and the patterned wafer. The numerals in Table 1 represent the proportion by mass of the respective components to the total mass of the polishing compound, and the unit is %.

The polishing conditions were as described below, and the removal rate when the wafer for evaluating removal rate of copper was polished with each polishing compound, was measured by using a film thickness measuring apparatus (RT80-RG80, manufactured by Napson Corporation). Further, with respect to polishing of the patterned wafer, dishing at a position with the line width of 50 µm was measured by using a profilometer (Dektak V200Si manufactured by Veeco Instruments). The results are shown in Table 2. In Table 2, the unit of the removal rate is nm/min, and the unit of dishing is nm.

### (Polishing conditions)

Polishing machine: Polishing machine 6EC manufactured by Strasbaugh
Polishing pad: IC-1000 K-Grooved (manufactured by Rodel, Inc.)
Polishing compound supply amount: 200 mL/min (corresponding to 0.082 mL/(min×cm²))
Polishing time: 1 minute
Polishing pressure: 1.7×10⁴ Pa
Number of revolutions of polishing pad: Head (board holding portion) 97 rpm, platen 103 rpm

### EXAMPLES 4 to 6

Using each polishing compound having a composition as shown in Table 1, polishing was carried out on the patterned wafer in Examples 4 and 5. In Examples 4 to 6, polishing was carried out also on the wafer for evaluating removal rate of copper, and in Examples 4 and 6, polishing was carried out also on the wafer for evaluating removal rate of tantalum, and the removal rate of copper and the removal rate of tantalum were compared.

The polishing conditions were as described below, and the removal rates when the wafer for evaluating removal rate of copper and the wafer for evaluating removal rate of tantalum were polished were measured by using a film thickness measuring apparatus (tencor RS-75 manufactured by KLA-Tencor Corporation). Further, with respect to the polishing of the patterned wafer, dishing at a position with the line width of 50 µm was measured by using a profilometer (tencor HRP-100 manufactured by KLA-Tencor Corporation). The results are shown in Table 2.

### (Polishing conditions)

Polishing machine: Polishing machine Mirra manufactured by Applied Materials, Inc.
Polishing pad: IC-1000 K-Grooved (manufactured by Rodel, Inc.).
Polishing compound supply amount: 200 mL/min (corresponding to 0.099 mL/(min×cm²))
Polishing time: 1 minute
Polishing pressure: 0.7×10⁴ Pa
Number of revolutions of polishing pad: Head 137 rpm, platen 143 rpm

### EXAMPLES 7 and 8

Using each polishing compound having a composition as shown in Table 1, polishing was carried out on the wafer for evaluating removal rate of copper and the wafer for evaluating removal rate of tantalum in the same manner as in Example 4. Polishing was carried out in the same manner as in Example 4 except that the polishing compound supply amount was changed to 100 mL/min. The results are shown in Table 2.

**TABLE 1**

| | Ex. 1 | Ex. 2 | Ex. 3 | Ex. 4 | Ex. 5 | Ex. 6 | Ex. 7 | Ex. 8 |
|---|---|---|---|---|---|---|---|---|
| δ-alumina | 2.77 | 2.77 | 2.77 | 2.77 | 2.77 | 2.77 | 0.95 | 0.95 |
| Tartaric acid | 0.92 | 0.92 | 0 | 0.92 | 0 | 0.92 | 0.95 | 0.95 |
| Malonic acid | 0.92 | 0 | 1.85 | 0.92 | 1.85 | 0.92 | 0.95 | 0.95 |
| Maleic acid | 0 | 0.92 | 0 | 0.92 | 0 | 0 | 0 | 0 |
| BTA | 0.046 | 0.046 | 0.046 | 0.009 | 0 | 0.009 | 0.029 | 0.010 |
| THMAM | 3.69 | 3.69 | 3.69 | 3.69 | 3.69 | 0 | 1.90 | 3.81 |
| Ammonia | 0 | 0 | 0 | 0 | 0 | 0.46 | 0.24 | 0 |
| H₂O₂ | 2.31 | 2.31 | 2.31 | 2.31 | 2.31 | 2.31 | 1.43 | 1.43 |
| Water | the rest | the rest | the rest | the rest | the rest | the rest | the rest | the rest |
| pH | 6.5 | 6.5 | 6.5 | 6.5 | 6.5 | 6.5 | 7 | 7 |

**TABLE 2**

| | Ex. 1 | Ex. 2 | Ex. 3 | Ex. 4 | Ex. 5 | Ex. 6 | Ex. 7 | Ex. 8 |
|---|---|---|---|---|---|---|---|---|
| Copper removal rate | 838 | 795 | 1034 | 578 | 527 | 381 | 929 | 696 |
| Ta removal rate | - | - | - | 0.5 | - | 33 | 3.3 | 1.7 |
| Dishing | 100 | 100 | 190 | 55 | 130 | - | - | - |

### INDUSTRIAL APPLICABILITY

According to the present invention, the copper wiring on the surface of a semiconductor integrated circuit board can be polished at a high removal rate while suppressing formation of scars as defects in a polishing step. Particularly in a first polishing step of polishing copper wirings having a film made of tantalum or a tantalum compound as a barrier film, excellent selectivity will be obtained, dishing and erosion due to polishing are less likely to occur, and an extremely high precision flat surface of a semiconductor integrated circuit board can be obtained.

Further, according to the present invention, a high removal rate and high selectivity can be obtained even under a low polishing pressure in a step of polishing the surface of a semiconductor integrated circuit board, and accordingly problems such as peeling of an insulating film are less likely to arise even when a film made of a low-k material having a low dielectric constant, such as an organic material or an organic/inorganic composite material is used as an insulating film.

## Claims

1. A polishing compound for chemical mechanical polishing of a substrate, which comprises the following components (A), (B), (C), (D) and (E):
(A) abrasive grains
(B) aqueous medium
(C) tartaric acid
(D) trishydroxymethylaminomethane
(E) at least one member selected from the group consisting of malonic acid and maleic acid.

2. The polishing compound according to Claim 1, wherein the component (C) is contained in an amount of from 0.01 to 10 mass%, the component (D) is contained in an amount of from 0.01 to 10 mass% and the component (E) is contained in an amount of from 0.01 to 10 mass%, to the total mass of the polishing compound.

3. The polishing compound according to Claim 1 or 2, which further contains a compound of the formula 1 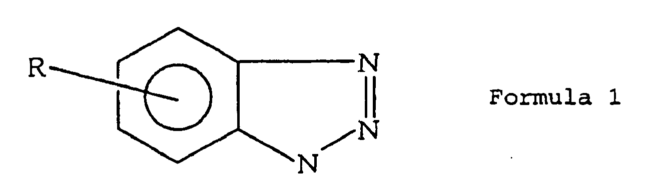 wherein R is a hydrogen atom, a C₁₋₄ alkyl group, a C₁₋₄ alkoxy group or a carboxylic acid group.

4. The polishing compound according to any one of Claims 1 to 3, which further contains an oxidizing agent in an amount of from 0.1 to 10 mass%.

5. The polishing compound according to any one of Claims 1 to 4, which further contains ammonia in an amount of from 0.05 to 0.4 mass%.

6. A process for producing a semiconductor integrated circuit board, which comprises forming an insulating film on a wafer and forming copper embedded wirings in the insulating film by means of a barrier film made of tantalum or a tantalum compound, **characterized by** having steps of bringing the surface of the wafer into contact with a polishing pad, supplying a polishing compound for chemical mechanical polishing comprising the following components (A), (B), (C), (D) and (E) to a space between the board and the polishing pad, and polishing copper formed on the surface of the wafer:
(A) abrasive grains
(B) aqueous medium
(C) tartaric acid
(D) trishydroxymethylaminomethane
(E) at least one member selected from the group consisting of malonic acid and maleic acid.

7. The process for producing a semiconductor integrated circuit board according to Claim 6, wherein the component (C) is contained in an amount of from 0.01 to 10 mass%, the component (D) is contained in an amount of from 0.01 to 10 mass% and the component (E) is contained in an amount of from 0.01 to 10 mass%, to the total mass of the polishing compound.

8. The process for producing a semiconductor integrated circuit board according to Claim 6 or 7, wherein the polishing compound further contains a compound of the formula 1: 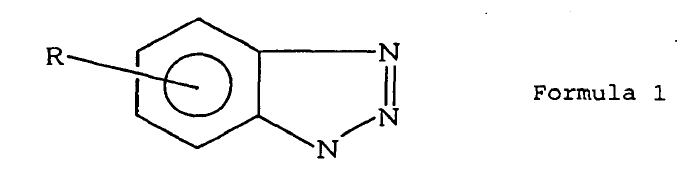 wherein R is a hydrogen atom, a C₁₋₄ alkyl group, a C₁₋₄ alkoxy group or a carboxylic acid group.

9. The process for producing a semiconductor integrated circuit board according to any one of Claims 6 to 8, wherein the polishing compound further contains an oxidizing agent in an amount of from 0.1 to 10 mass%.

10. The process for producing a semiconductor integrated circuit board according to any one of claims 6 to 9, wherein the polishing compound further contains ammonia in an amount of from 0.05 to 0.4 mass%.

11. The process for producing a semiconductor integrated circuit board according to any one of Claims 6 to 10, wherein the insulating film is made of an organic material or an organic/inorganic composite material having a low dielectric constant.

## Patentansprüche

1. Poliermittel zum chemisch-mechanischen Polieren eines Substrats, welches die folgenden Komponenten (A), (B), (C), (D) und (E) umfasst:
(A) Schleifkörner
(B) wäßriges Medium
(C) Weinsäure
(D) Trishydroxymethylaminomethan
(E) mindestens ein Mitglied, ausgewählt aus der Gruppe, bestehend aus Malonsäure und Maleinsäure.

2. Poliermittel nach Anspruch 1, wobei die Komponente (C) in einer Menge von 0,01 bis 10 Massen-% enthalten ist, die Komponente (D) in einer Menge von 0,01 bis 10 Massen-% enthalten ist und die Komponente (E) in einer Menge von 0,01 bis 10 Massen-% enthalten ist, bezüglich der Gesamtmasse des Poliermittels.

3. Poliermittel nach Anspruch 1 oder 2, welches weiter eine Verbindung der Formel 1 enthält 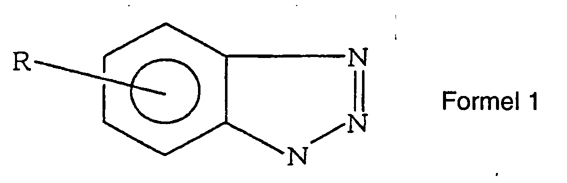 wobei R ein Wasserstoffatom, eine C₁₋₄ Alkylgruppe, eine C₁₋₄ Alkoxygruppe oder eine Carbonsäuregruppe ist.

4. Poliermittel nach einem der Ansprüche 1 bis 3, welches weiter ein Oxidationsmittel in einer Menge von 0,1 bis 10 Massen-% enthält.

5. Poliermittel nach einem der Ansprüche 1 bis 4, welches weiter Ammoniak in einer Menge von 0,05 bis 0,4 Massen-% enthält.

6. Verfahren zur Herstellung einer integrierten Halbleiterschaltplatte, welches das Bilden eines Isolierfilms auf einem Wafer und das Bilden von eingebetteten Kupferleitungen in dem Isolierfilm mittels eines aus Tantal oder einer Tantalverbindung hergestellten Barrierefilms umfasst, **gekennzeichnet durch** das Aufweisen der Schritte des Inkontaktbringens der Oberfläche des Wafers mit einem Polierkissen, des Aufbringens eines Poliermittels zum chemisch-mechanischen Polieren, umfassend die folgenden Komponenten (A), (B), (C), (D) und (E), in einen Raum zwischen der Platte und dem Polierkissen, und des Polierens des auf der Oberfläche des Wafers gebildeten Kupfers:
(A) Schleifkörner
(B) wäßriges Medium
(C) Weinsäure
(D) Trishydroxymethylaminomethan
(E) mindestens ein Mitglied, ausgewählt aus der Gruppe, bestehend aus Malonsäure und Maleinsäure.

7. Verfahren zur Herstellung einer integrierten Halbleiterschaltplatte nach Anspruch 6, wobei die Komponente (C) in einer Menge von 0,01 bis 10 Massen-% enthalten ist, die Komponente (D) in einer Menge von 0,01 bis 10 Massen-% enthalten ist und die Komponente (E) in einer Menge von 0,01 bis 10 Massen-% enthalten ist, bezüglich der Gesamtmasse des Poliermittels.

8. Verfahren zur Herstellung einer integrierten Halbleiterschaltplatte nach Anspruch 6 oder 7, wobei das Poliermittel weiter eine Verbindung der Formel 1 enthält 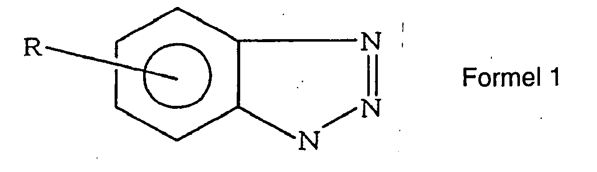 wobei R ein Wasserstoffatom, eine C₁₋₄ Alkylgruppe, eine C₁₋₄ Alkoxygruppe oder eine Carbonsäuregruppe ist.

9. Verfahren zur Herstellung einer integrierten Halbleiterschaltplatte nach einem der Ansprüche 6 bis 8, wobei das Poliermittel weiter ein Oxidationsmittel in einer Menge von 0,1 bis 10 Massen-% enthält.

10. Verfahren zur Herstellung einer integrierten Halbleiterschaltplatte nach einem der Ansprüche 6 bis 9, wobei das Poliermittel weiter Ammoniak in einer Menge von 0,05 bis 0,4 Massen-% enthält.

11. Verfahren zur Herstellung einer integrierten Halbleiterschaltplatte nach einem der Ansprüche 6 bis 10, wobei der Isolierfilm aus einem organischen Material oder einem organisch/anorganischen Kompositmaterial mit einer niedrigen dielektrischen Konstante hergestellt ist.

## Revendications

1. Composition de polissage pour un polissage chimico-mécanique d'un substrat, qui comprend les composants (A), (B), (C), (D) et (E) suivants :
(A) grains abrasifs
(B) milieu aqueux
(C) acide tartrique
(D) trishydroxyméthylaminométhane
(E) au moins un élément sélectionné dans le groupe constitué de l'acide malonique et de l'acide maléique.

2. Composition de polissage selon la revendication 1, dans laquelle le composant (C) est présent en une quantité de 0,01 à 10% en masse, le composant (D) est présent en une quantité de 0,01 à 10% en masse et le composant (E) est présent en une quantité de 0,01 à 10% en masse, par rapport à la masse totale de la composition de polissage.

3. Composition de polissage selon la revendication 1 ou 2, qui contient en outre un composé de formule 1 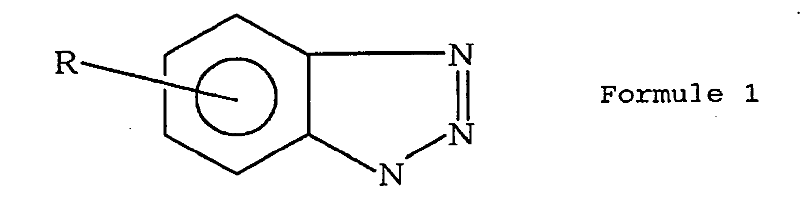 dans laquelle R est un atome d'hydrogène, un groupe alkyle en C₁₋₄, un groupe alkoxy en C₁₋₄ ou un groupe acide carboxylique.

4. Composition de polissage selon l'une quelconque des revendications 1 à 3, qui contient en outre un agent oxydant en une quantité de 0,1 à 10% en masse.

5. Composition de polissage selon l'une quelconque des revendications 1 à 4, qui contient en outre de l'ammoniac en une quantité de 0,05 à 0,4% en masse.

6. Procédé de production d'une plaquette de circuit intégré à semiconducteur, qui comprend la formation d'un film isolant sur une tranche et la formation de câblages noyés en cuivre dans le film isolant au moyen d'un film formant barrière constitué de tantale ou d'un composé du tantale,
**caractérisé par** les étapes de mise en contact de la surface de la tranche avec un tampon de polissage, l'alimentation d'un espace compris entre la plaquette et le tampon de polissage avec une composition de polissage pour un polissage chimico-mécanique comprenant les composants (A), (B), (C), (D) et (E) suivants et le polissage du cuivre formé à la surface de la tranche :
(A) grains abrasifs
(B) milieu aqueux
(C) acide tartrique
(D) trishydroxyméthylaminométhane
(E) au moins un élément sélectionné parmi le groupe constitué de l'acide malonique et de l'acide maléique.

7. Procédé de production d'une plaquette de circuit intégré à semiconducteur selon la revendication 6, dans lequel le composant (C) est présent en une quantité de 0,01 à 10% en masse, le composant (D) est présent en une quantité de 0,01 à 10% en masse et le composant (E) est présent en une quantité de 0,01 à 10% en masse, par rapport à la masse totale de la composition de polissage.

8. Procédé de production d'une plaquette de circuit intégré à semiconducteur selon la revendication 6 ou 7, dans lequel la composition de polissage contient en outre un composé de formule 1 : 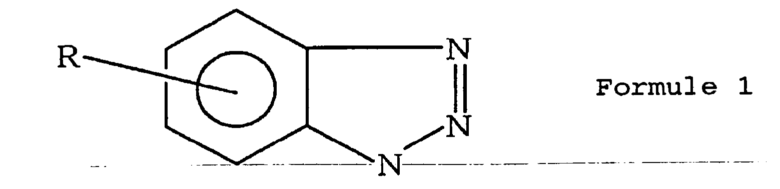 dans laquelle R est un atome d'hydrogène, un groupe alkyle en C₁₋₄, un groupe alkoxy en C₁₋₄ ou un groupe acide carboxylique.

9. Procédé de production d'une plaquette de circuit intégré à semiconducteur selon l'une quelconque des revendications 6 à 8, dans lequel la composition de polissage contient en outre un agent oxydant en une quantité de 0,1 à 10% en masse.

10. Procédé de production d'une plaquette de circuit intégré à semiconducteur selon l'une quelconque des revendications 6 à 9, dans lequel la composition de polissage contient en outre de l'ammoniac en une quantité de 0,05 à 0,4% en masse.

11. Procédé de production d'une plaquette de circuit intégré à semiconducteur selon l'une quelconque des revendications 6 à 10, dans lequel le film isolant est constitué d'un matériau organique ou d'un matériau composite organique/inorganique ayant une constante diélectrique faible.
